# EUROPEAN PATENT APPLICATION

(11) **EP 4 814 963 A1**
(43) Date of publication of application: **30.09.2026**
(21) Application number: 26162599.0
(22) Date of filing: 05.03.2026
(51) Int. Cl.: G11C 11/00, G11C 17/16, G11C 17/18

(54) **DYNAMIC RANDOM-ACCESS MEMORY (DRAM) CONVERTIBLE TO PERMANENT STORAGE**

(30) Priority: 26.03.2025 US 202519091244
(71) Applicant: NXP USA, Inc, Austin, TX 78735 (US)
(72) Inventor: Mahatme, Nihaar N., 5656 AG Eindhoven (NL); Shroff, Mehul D., 5656 AG Eindhoven (NL)
(74) Representative: Krott, Michel

(57) **Abstract**

A dynamic random-access memory (DRAM) includes an array of bit cells, each bit cell having a corresponding access transistor coupled to a corresponding word line and a corresponding bit line, a corresponding storage transistor having a gate electrode coupled to a first current electrode of the corresponding access transistor, a corresponding capacitor having a first terminal coupled to the gate electrode of the storage transistor at a corresponding storage node, and a corresponding diode coupled between a second terminal of the corresponding capacitor and a corresponding voltage supply node. The DRAM includes a controller configured to convert a selected bit cell of the array of bit cells to one-time-programmable (OTP) memory by turning on the corresponding access transistor of the selected bit cell and applying a voltage differential between the corresponding bit line and the corresponding voltage supply node sufficient to permanently break down a dielectric of the corresponding capacitor.

## Description

### Background

### Field

This disclosure relates generally to memories, and more specifically, to a dynamic random-access memory (DRAM) convertible to permanent storage.

### Related Art

Read Only Memories (ROMs) are commonly used to permanently store information. However, once written, they cannot be re-programmed, which causes problems when information needs updating, such as when software bugs are discovered in the field. Also, the content which is permanently stored in ROMs is typically discoverable, therefore, it is undesirable to use ROMs for permanent storage of secret information. Therefore, a need exists for different memory architectures to be used as permanent storage.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIGs. 1 and 2 illustrate, in schematic form, DRAM bit cells in accordance with embodiments of the present invention.
FIG. 3 illustrates, in schematic form, a portion of a DRAM array having the DRAM bit cell of FIG. 2, in accordance with an embodiment of the present invention.
FIG. 4 illustrates, in flow diagram form, a method of operating the DRAM array of FIG. 3, in accordance with an embodiment of the present invention.
FIG. 5 illustrates, in block diagram form, a System on Chip (SoC) including the DRAM array of FIG. 4, in accordance with an embodiment of the present invention.

### Detailed Description

In one aspect, an embedded dynamic random-access memory (DRAM) is used as re-programmable memory which can subsequently be converted to read-only memory. For example, the DRAM can be used as programmable memory (which can be reprogrammed as needed) until software validation is completed, at which point it can be converted to permanent storage. The conversion to permanent storage can be performed by destroying a storage dielectric of a DRAM bit cell. The permanent destruction of the storage dielectric may include the destruction of the gate dielectric of a storage transistor of the DRAM bit cell or of a metal-insulator-metal (MIM) capacitor of the DRAM bit cell present to extend the cell's retention time (or both). In one embodiment, particular bit cells of a DRAM array can be selected for conversion to permanent memory based on knowledge of the break-down and punch-through voltages (VBD and Vpunch-through, respectively) of the different transistors of the array. In this manner, the appropriate voltages can be applied for the conversion, while allowing the cells to operate normally prior to conversion. Note that the bit cells which are converted to permanent memory can be referred to as forming one-time-programmable (OTP) memory (or forming a ROM), since, once they are programmed (e.g. converted), their stored value can no longer be changed.

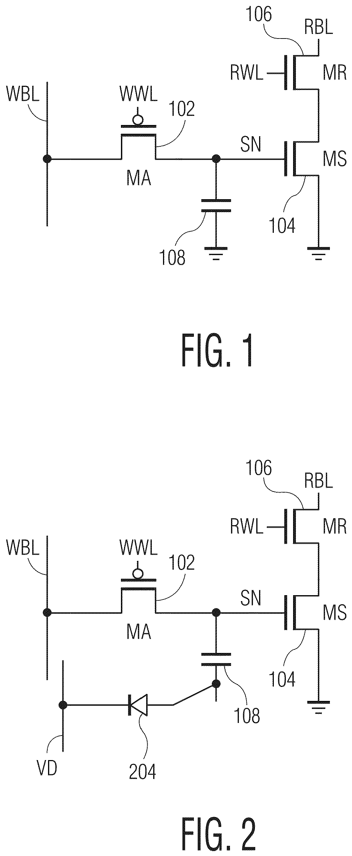

FIG. 1 illustrates, in schematic form, an embodiment of a DRAM bit cell 100, in accordance with one embodiment of the present invention. Cell 100 includes an access transistor (MA) 102, a storage transistor (MS) 104, a read access (MR) transistor 106, and a capacitor 108. In the illustrated embodiment, MA 102 is implemented as a p-channel metal-oxide-semiconductor (PMOS) transistor, while MR 106 and MS 104 are implemented as n-channel metal-oxide-semiconductor (NMOS) transistors. Note that capacitor 108 may simply be referred to as a capacitor or trench capacitor and, in alternate embodiments, may be implemented with different types of capacitors. In one embodiment of FIG. 1, capacitor 108 may instead refer to the capacitance provided by a parasitic capacitance of MS 104. In alternate embodiments, transistors 102, 104, and 106 may have different polarities.

In the illustrated embodiment, each of MR 106 and MS 104 are implemented as low-voltage (LV) devices as compared to MA 102 which is implemented as a high-voltage (HV) device. As used herein, a largest voltage differential allowed over any two terminals of an LV device is lower than a largest voltage differential allowed over any two terminals of an HV device. Also, the VBD tolerance of an HV device is higher as compared to that of LV devices, and the breakdown time for HV devices is faster as compared to LV devices. In one embodiment, an HV device is implemented by making it larger than each of the LV devices. For example, in one embodiment, the HV device has a gate dielectric that is 50% thicker than the gate dielectric of an LV device. In another embodiment, the HV device has a channel length that is at least 5 times larger than the channel length of an LV device.

Cell 100 is coupled to a first voltage supply terminal configured to provide a high voltage supply (VDD), a higher voltage supply terminal configured to provide a higher voltage supply (VDD+) as compared to VDD, and a low voltage supply terminal configured to provide a low voltage supply (VSS), which is less than VDD. As will be described in reference to FIG. 2, a cell may also be coupled to a lower voltage supply terminal configured to provide a lower voltage supply (VSS-) which is less than VSS. Note that, for ease of explanation, each of the voltage supply terminals may simply be referred to by the voltage they supply (e.g. VDD, VDD+, VSS, VSS-).

Referring to cell 100 of FIG. 1, a first current electrode of MA 102 is coupled to a write bit line (WBL) and a second current electrode of MA 102 is coupled to a gate electrode of MS 104 and a first terminal of capacitor 108 (also referred to as the storage node (SN) of the cell). A gate electrode of MA 102 is coupled to a write word line (WWL). A second terminal of capacitor 108 is coupled to VSS. A first current electrode of MR 106 is coupled to a read bit line (RBL), a gate electrode of MR 106 is coupled to a read word line (RWL), and a second current electrode of MR 106 is coupled to a first current electrode of MS 104. A second current electrode of MS 104 is coupled to VSS.

In operation, during read, write, and retention mode, cell 100 performs normally, as known in the art, in which a charged capacitor at the SN of the cell indicates a first logic state while a discharged capacitor at the SN of the cell indicates a second logic state, opposite the first logic state. In the illustrated embodiments, this corresponds to the charged/discharged state of capacitor 108. Therefore, a write operation either charges or discharges capacitor 108. For example, when writing to cell 100, WBL is set to either VDD or VSS (depending on the state being programmed to cell 100), and WWL is set so as to turn on MA 102. If WBL is set to VDD, then capacitor 108 (e.g. SN) is charged, and if set to VSS, then capacitor 108 (e.g. SN) is discharged. During a write operation, RBL is set to VDD and RWL to VSS so as to turn off MR 106. For example, when reading from cell 100, RBL and RWL are both set to VDD in which if SN is charged, MS 104 is turned on resulting in a larger bit line current as compared to the case in which SN is discharged in which MS 104 is turned off. This current can be sensed to determined the stored state. Note that during a read operation, MA 102 is off.

For the charged state, over time, the charge on capacitor 108 may dissipate, thus risking losing its stored state. Therefore, a refresh operation can be performed periodically during the retention mode, as known in the art, for data retention. During a retention operation, MA 102 and MR 106 are off, and WBL is set to VDD. Note that in alternate embodiments, the voltages applied during the read, write, and retention operations may differ, based on the design of the cell.

In order to convert cell 100 to permanent storage (referred to as OTP conversion or ROM conversion), VDD+ (which is higher than VDD which is used during normal operation for reads and writes) is applied to WBL with MA 102 turned on so as to cause oxide breakdown of the capacitor 108. In alternate embodiments, capacitor 108 may include other dielectric materials in addition to or in place of an oxide, in which during the OTP conversion, the voltage differential over capacitor 108 is sufficient to permanently break down the dielectric of capacitor 108. Due to MA 102 being implemented as an HV device in the embodiment of FIG. 1, with a higher VBD tolerance as compared to the LV devices, MA 102 can withstand VDD+ being applied at its first current electrode. With MA 102 being on, VDD+ appears over capacitor 108, resulting in the permanent breakdown of the oxide. As a result of the OTP conversion in which the oxide of capacitor 108 is permanently broken down, cell 100 becomes a broken bit which is permanently programmed to the discharged state. Therefore, assuming the discharged state corresponds to a logic level zero, broken bits are permanently programmed to zero. (Note that, in alternate embodiments, the discharged state may correspond to a logic level one.)

FIG. 2 illustrates, in schematic form, an embodiment of a DRAM bit cell 200, in accordance with one embodiment of the present invention, in which like numerals with cell 100 of FIG. 1 illustrate like elements. As illustrated in FIG. 2, MA 102 is instead replaced with MA 202 which can be an LV device, such as MR 106 and MS 104. In this manner, the same core transistors can be used for the MA transistors of the DRAM. Also, in the embodiment of FIG. 2, rather than coupling the second terminal of capacitor 108 to VSS, a diode 204 is added in series with capacitor 108, in which the second terminal of capacitor 108 is instead coupled to an anode of diode 204. A cathode of diode 204 is coupled to the lower voltage supply terminal (labeled as VD) which is configured to receive VSS- during OTP conversion.

Cell 200 of FIG. 2 operates the same as cell 100 during read, write, and retention modes, in which VD can be set to 0 or VDD so that the diode path provided by diode 204 is turned off. However, during OTP conversion, VD is set to VSS- such that added diode 204 helps increase the effective drop across capacitor 108. In this manner, with MA 202 turned on, WBL can be set only to VDD rather VDD+ (in which MA 202 is not damaged), but the voltage differential over capacitor 108 is "VDD-(VSS-)", which is greater than VDD. In this manner, MA 202 is capable of being an LV device in which breakdown voltage is limited, while the fast breakdown times are maintained. With application of VDD to WBL, the voltage across the gate oxide of MA 202, as well as the punch-through voltage, are reduced. Therefore, as a result of the OTP conversion, the oxide of capacitor 108 is permanently broken down (as was described in reference to cell 100 of FIG. 1), such that cell 200 becomes a broken bit which is permanently programmed to the discharged state (e.g. which may correspond to a permanently stored logic level zero). Note that, in alternate embodiments, capacitor 108 may include other dielectric materials in addition to or in place of an oxide, in which during OTP conversion, the voltage differential over capacitor 108 is sufficient to permanently break down the dielectric of capacitor 108.

With respect to either cell 100 or cell 200, prior to the OTP conversion (i.e. ROM conversion), the cell operates normally, in which the cell can be programmed to store a logic level one or logic level zero (i.e. can be programmed to be in either the charged or discharged state). However, after OTP conversion, it is permanently programmed to the discharged state in which a permanent leaky resistive path to ground is created through capacitor 108. In the descriptions above, the OTP conversion permanently breaks down the oxide of capacitor 108 to create the leaky resistive path to ground. However, note that in doing so, the intrinsic gate capacitance of the corresponding MS transistor can also be permanently broken down. Once a bit is broken (permanently broken down), it can no longer be programmed to be in the charged state. In the descriptions which follow, it will be assumed that the discharged state corresponds to a logic level zero and the charged state to a logic level one (however, in alternate embodiments, the discharged state may correspond instead to the logic level one and the charged state to the logic level zero, in which a broken bit is permanently programmed to a one rather than a zero).

With respect to cell 200, the following table summarizes voltages that can be applied to WBL, WWL, VD, RBL, and RWL during each of a read operation, write operation, OTP conversion operation, and retention operation. Note that similar voltages can be used for cell 100, except, during an OTP conversion operation, WBL can be set to VDD+. Also, for cell 200, for the OTP conversion operation, if an HV PMOS is used as the MA transistor instead of an LV PMOS device, WWL can also be set to VDD+ rather than VDD. This allows "(VDD+) - (VSS-)" to be applied over capacitor 108.

| | **Read** | **Write** | **OTP Conversion** | **Retention** |
|---|---|---|---|---|
| **WBL** | VDD | VDD / 0V | VDD | VDD |
| **VD** | VSS | VSS | VSS- | VSS |
| **WWL** | VSS | ON | ON | OFF |
| **RBL** | VDD | VDD | VDD | VDD |
| **RWL** | VDD | VSS | VSS | VSS |

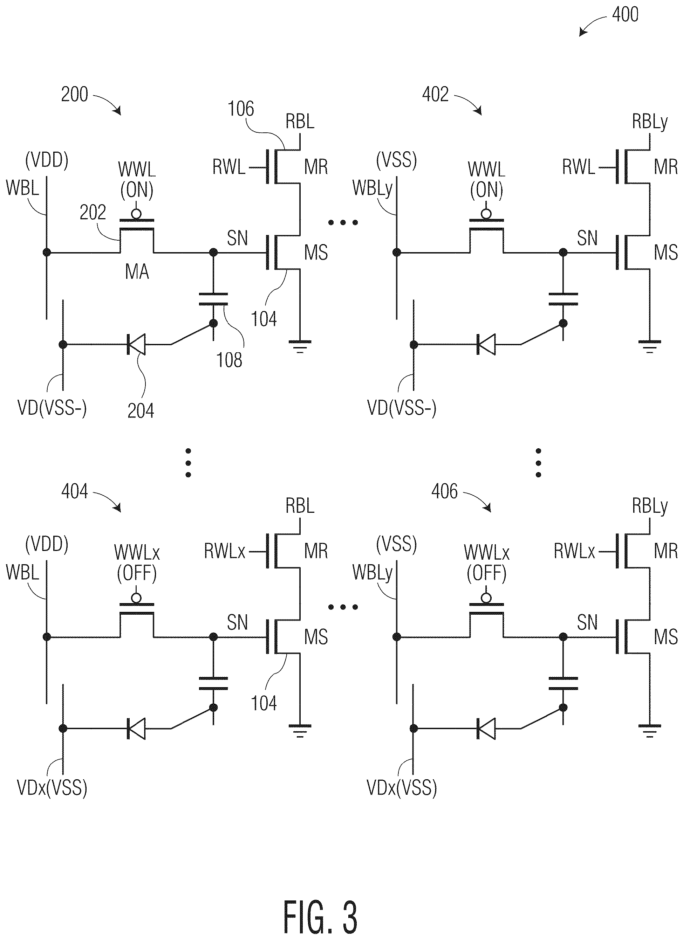

FIG. 3 illustrates, in schematic form, a portion of a DRAM array 400, in accordance with an embodiment of the present invention, in which DRAM array 400 includes cell 200 (as described above in reference to FIG. 2), along with a bit cell 402 located in a same row but different column as cell 200, a bit cell 404 located in a same column but different row as cell 200, and a bit cell 406 located in a different row and different column than cell 200. DRAM array 400 can have any number of rows and columns, in which each row has a corresponding read word line and write word line and each column has a corresponding read bit line and write bit line. Cells 200 and 402 can be in immediately adjacent columns or have any number of columns in between, and similarly, cells 200 and 404 can be in immediately adjacent rows of have any number of rows in between. In the illustrated embodiment, each cell includes the same elements and architecture as described above in reference to cell 200. Therefore, each cell includes corresponding MS, MR, and MS transistors (analogous to MS 202, MR 106, and MS 104 of cell 200), a corresponding capacitor and corresponding SN (analogous to capacitor 108 of cell 200 whose first terminal corresponds to SN), and a corresponding diode (analogous to diode 204 of cell 200).

Since cells 200 and 402 are in the same row, the gate electrodes of each of the corresponding MR and MA transistors of the cells are coupled to the same word lines (RWL and WWL, respectively). Similarly, since cells 404 and 406 are in the same row, the gate electrodes of each of the corresponding MR and MA transistors of the cells are coupled to the same word lines (RWLx and WWLx, respectively). In the illustrated embodiment, VD runs along the word lines within each row (and may also be referred to as a voltage supply rail), therefore, the cathodes of the corresponding diodes of cells 200 and 402 are coupled to VD, and the cathodes of the corresponding diodes of cells 404 and 406 are coupled to VDx. Since cells 200 and 404 are in the same column, the first current electrodes of each of the corresponding MR and MA transistors of the cells are coupled to the same bit lines (RBL and WBL, respectively). Similarly, since cells 402 and 406 are in the same column, the first current electrodes of each of the corresponding MR and MA transistors of the cells are coupled to the same bit lines (RBLy and WBLy, respectively). Note that the state of the corresponding MA transistors as ON or OFF or example values of some of the word lines (e.g. WBL, WBLy) and voltage rails (e.g. VD and VDx) are provided in parenthesis in FIG. 3 to represent example values during an OTP conversion operation on cell 200, as will be described in more detail below.

Read, write, and retention operations can be performed on DRAM array 400, as known in the art, in which (prior to OTP conversion of any of the cells of the array), the cells can be programmed and re-programmed, as needed. The OTP conversion of any of the cells can be performed by selecting a particular cell (or group of cells) and applying the bias voltages described above for OTP conversion. Referring to FIG. 3 as an example, assuming an OTP conversion operation is being performed on selected cell 200, then cell 200 is considered as being in the selected row and selected column (as selected, for example, by known column and row decoders for DRAM array 400). For the selected row, WWL is set so as to turn the corresponding MA transistors ON. In the illustrated embodiment, cell 402 is considered to be in the selected row but an unselected column, cell 404 is in the selected column but an unselected row, and cell 406 is in an unselected row and unselected column. During the OTP operation, for selected cell 200, a high bias is applied to capacitor 108 by setting WBL to VDD and VD to VSS-, as described above, such that the cell capacitance is permanently broken down to create an OTP cell.

During the OTP creation operation on selected cell 200, any unselected cells in a selected row but unselected column (such as cell 402) has a low bias voltage by setting WBL to VSS while VD is set to VSS-. While the application of "VSS - (VSS-)" over the corresponding capacitor may disturb the cell contents by affecting the capacitance of the corresponding capacitor, the cell capacitor will not be broken down, therefore no OTP is created. Cells in the unselected row (e.g. cells 404 and 406), the corresponding WWL (e.g. WWLx) is set so as to turn OFF the corresponding MA transistors. Therefore, no bias voltage is applied over the corresponding capacitors, and no OTP is created.

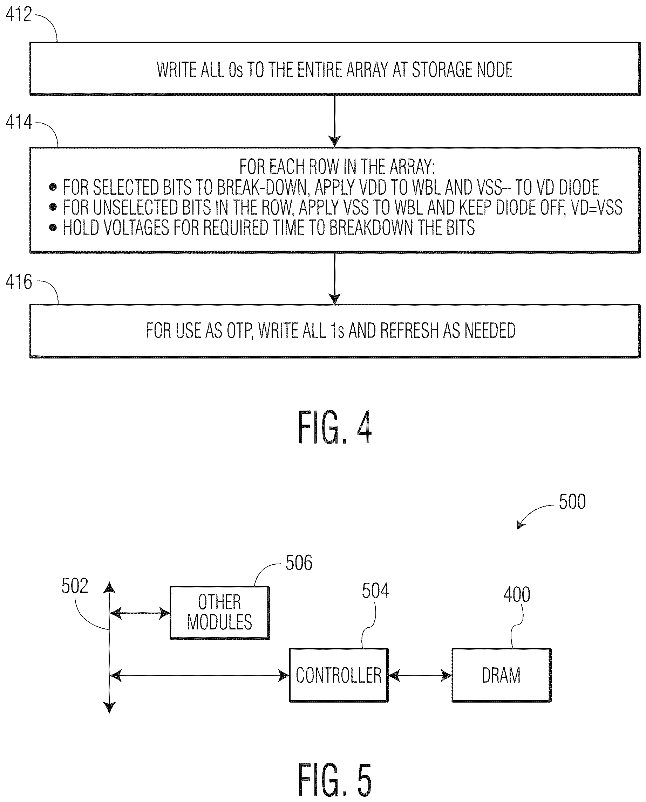

In operation, DRAM array 400 can be used as re-programmable memory until data is to be permanently stored, at which point DRAM array 400 can be converted to an OTP memory (i.e. a ROM). FIG. 4 illustrates, in flow diagram form, a method for converting DRAM array 400 (also referred to as DRAM 400) into an OTP memory. Upon conversion to an OTP memory, at block 412, the array can be conditioned by writing the entire array to logic level 0s at the storage nodes (corresponding to the discharged state). Then, at block 414, for each row of DRAM array 400, selected in turn, the WWL for the selected row is set to a voltage so as to turn on the corresponding MA transistors of the bit cells in the selected row, and, for selected bit cells of the row that are to be permanently programmed as a logic level 0 (to the discharged state), VDD is applied to WBL and VSS- is applied to VD. For the unselected bit cells of the row (that are not being permanently programmed), VSS is applied to WBL and the corresponding diode is maintained off by applying VSS to VD. Once the appropriate voltages are applied for the selected and unselected bit cells of the row, the voltages are held for the required time sufficient to break down the capacitor oxide of the selected bits. This is repeated for each row of the array, until the entire array has been programmed accordingly, in which selected bits are broken down to form broken bits which permanently store a logic level zero.

Next, at block 416, when DRAM array 400 is to be accessed as an OTP (or any time array 400 is powered up, the entire array is written to a logic level one (corresponding to the charged state). For example, each row of array 400 can be accessed in turn, in which ones are written to all the bit cells of each selected row. Note that for the broken bits in each row, programming a one to that bit cell will not change the state of the bit cell, it will remain as a permanent logic level zero. However, for any bits which are not broken, a one will be programmed to the storage node. Note that, in using array 400, it also needs to be refreshed, using any known refresh scheme, such that the bits programmed to a logic level one maintain their states.

Therefore, in this manner, array 400 represents an OTP array in which the desired values are permanently programmed into the array by permanently storing the zeros (in which any bit cell that does not permanently store a zero corresponds to storing a one). Even if power is removed or the bitcells storing the charged states are discharged, the original permanently stored values can be re-established by refreshing the entire array to ones. For example, upon a boot-up of a system on chip (SoC) having DRAM array 400, the boot flow can include a refresh of DRAM array 400 to reestablish the permanently stored information.

FIG. 5 illustrates an SoC 500, in accordance with an embodiment of the present invention, which includes DRAM array 400 and a functional controller 504 coupled to DRAM array 400. Also illustrated in FIG. 5 is a system interconnect 502 of SoC 500, which can be any type of interconnect which allows communication with any other modules 506 within SoC 500. In one embodiment, upon a power up of SoC 500, a boot flow begins which can directly activate controller 504. Upon activation, controller 504 can use counters to increment an address to serially select each row of DRAM array 400 and to write all ones to each selected row. Again, only those bits which are not broken will be programmed to a logic level one, while the broken bits will remain at the permanently stored logic level zero. In one embodiment, after ones are written to the entire array, a built-in self-test (BIST) can be run to verify the programming of DRAM array 400, in which repair can be applied if needed. The boot flow can then be resumed, in which DRAM array 400 is ready for use in the field, in which periodic refresh operations can be performed, as needed, to maintain the charged states.

In one embodiment, controller 504 can receive access signals for accessing data in DRAM array 400 via system interconnect 502, such as read and write access requests, each with a corresponding access address and control signals (e.g. such as a R/W control signal). Controller 504 can include the column and row decoders for DRAM array 400, write circuitry, sensing circuitry, and any other circuitry for performing the write, read, and refresh operations, as known in the art. Controller 504 can also provide the voltage signals, as needed, to the voltage supply terminals of DRAM array 400. Although illustrated as separate from DRAM 400, controller 504 can be considered to be part of the DRAM. Other modules 506 of SoC 502 can include any number and any type of module, such as cores, memories, peripherals, etc.

By now it can be understood how a DRAM array can first be used as normal re-programmable memory and then converted into an OTP memory (e.g. a ROM) by breaking selected bits to be in a permanently discharged state. In doing so, upon power up or during operation, the DRAM array with broken bits can be refreshed to the charged state, in which the refresh will only refresh those bits which are not broken to the charged state while the broken bits remain in the discharged state. In this manner, the broken bits permanently store the logic state corresponding to the discharged state (e.g. a logic level zero). In one embodiment, a diode is added in series with the capacitor of each DRAM bit cell to increase the voltage differential over the capacitor of the cell in order to break the capacitor oxide without harming other devices of the cell. In one embodiment, the access transistor of the DRAM bit cell can be implemented as an HV device in which a greater voltage (e.g. VDD+) than used during normal operation can be applied to the capacitor for breaking the capacitor oxide. In breaking the capacitor of the bit cell, note that the gate oxide of the storage device of the cell may also be broken, to further reinforce the permanent broken state.

As used herein, the term "bus" is used to refer to a plurality of signals or conductors which may be used to transfer one or more various types of information, such as data, addresses, control, or status. The conductors as discussed herein may be illustrated or described in reference to being a single conductor, a plurality of conductors, unidirectional conductors, or bidirectional conductors. However, different embodiments may vary the implementation of the conductors. For example, separate unidirectional conductors may be used rather than bidirectional conductors and vice versa. Also, plurality of conductors may be replaced with a single conductor that transfers multiple signals serially or in a time multiplexed manner. Likewise, single conductors carrying multiple signals may be separated out into various different conductors carrying subsets of these signals. Therefore, many options exist for transferring signals.

The terms "assert" or "set" and "negate" (or "deassert" or "clear") are used herein when referring to the rendering of a signal, status bit, or similar apparatus into its logically true or logically false state, respectively. If the logically true state is a logic level one, the logically false state is a logic level zero. And if the logically true state is a logic level zero, the logically false state is a logic level one.

Each signal described herein may be designed as positive or negative logic, where negative logic can be indicated by a bar over the signal name or an asterisk (*) following the name. In the case of a negative logic signal, the signal is active low where the logically true state corresponds to a logic level zero. In the case of a positive logic signal, the signal is active high where the logically true state corresponds to a logic level one. Note that any of the signals described herein can be designed as either negative or positive logic signals. Therefore, in alternate embodiments, those signals described as positive logic signals may be implemented as negative logic signals, and those signals described as negative logic signals may be implemented as positive logic signals.

Because the apparatus implementing the present invention is, for the most part, composed of electronic components and circuits known to those skilled in the art, circuit details will not be explained in any greater extent than that considered necessary as illustrated above, for the understanding and appreciation of the underlying concepts of the present invention and in order not to obfuscate or distract from the teachings of the present invention.

Although the invention has been described with respect to specific conductivity types or polarity of potentials, skilled artisans appreciated that conductivity types and polarities of potentials may be reversed.

Moreover, the terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Some of the above embodiments, as applicable, may be implemented using a variety of different information processing systems. For example, although FIG. 5 and the discussion thereof describe an exemplary information processing architecture, this exemplary architecture is presented merely to provide a useful reference in discussing various aspects of the invention. Of course, the description of the architecture has been simplified for purposes of discussion, and it is just one of many different types of appropriate architectures that may be used in accordance with the invention. Those skilled in the art will recognize that the boundaries between logic blocks are merely illustrative and that alternative embodiments may merge logic blocks or circuit elements or impose an alternate decomposition of functionality upon various logic blocks or circuit elements. Thus, it is to be understood that the architectures depicted herein are merely exemplary, and that in fact many other architectures can be implemented which achieve the same functionality.

Also for example, in one embodiment, DRAM array 400 is an embedded DRAM array within SoC 500, in which the elements of SoC 500 are circuitry located on a single integrated circuit or within a same device. Furthermore, those skilled in the art will recognize that boundaries between the functionality of the above described operations merely illustrative. The functionality of multiple operations may be combined into a single operation, and/or the functionality of a single operation may be distributed in additional operations. Moreover, alternative embodiments may include multiple instances of a particular operation, and the order of operations may be altered in various other embodiments.

Although the invention is described herein with reference to specific embodiments, various modifications and changes can be made without departing from the scope of the present invention as set forth in the claims below. For example, in alternate embodiments, rather than using 3T (3-transistor) DRAM bit cells of FIGs. 1 and 2, 2T (2-transistor) DRAM bit cells can be used in which, for example, in each of cells 100 and 200, the corresponding MR transistor may not be present such that the first current electrode of the MS transistor of each cell is coupled to RBL and the second current electrode of the MS transistor of each cell is coupled to RWL. However, regardless, the 2T implementation includes the corresponding capacitor and can also include the corresponding diode in series with the corresponding capacitor. The 2T implementation can also implement the MA transistor as a HV device. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

The term "coupled," as used herein, is not intended to be limited to a direct coupling or a mechanical coupling.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

The following are various embodiments of the present invention. Note that any of the aspects below can be used in any combination with each other and with any of the disclosed embodiments.

In an embodiment, a dynamic random-access memory (DRAM) includes an array of bit cells, each bit cell having a corresponding access transistor coupled to a corresponding word line and a corresponding bit line, a corresponding storage transistor having a gate electrode coupled to a first current electrode of the corresponding access transistor, a corresponding capacitor having a first terminal coupled to the gate electrode of the storage transistor at a corresponding storage node, and a corresponding diode coupled between a second terminal of the corresponding capacitor and a corresponding voltage supply node; and a controller configured to convert a selected bit cell of the array of bit cells to one-time-programmable (OTP) memory by turning on the corresponding access transistor of the selected bit cell and applying a voltage differential between the corresponding bit line and the corresponding voltage supply node sufficient to permanently break down a dielectric of the corresponding capacitor. In one aspect, for each bit cell, an anode of the corresponding diode is coupled to the second terminal of the corresponding capacitor, and a cathode of the corresponding diode is coupled to the corresponding voltage supply node. In a further aspect, the controller is configured to, during OTP conversion of the selected bit cell to OTP memory, supply a negative voltage to the corresponding voltage supply node. In another further aspect, the controller is configured to, during read, write, and retention operations on bit cells of the array, supply a voltage to the corresponding voltage supply node to turn off a diode path through the corresponding diode. In another aspect of the above embodiment, the corresponding storage node of each bit cell of the array, prior to OTP conversion, is programmable to a charged state or a discharged state, in which the charged state corresponds to a first logic state and the discharged state to a second logic state, different than the first logic state. In a further aspect, after OTP conversion, the selected bit cell is permanently in the discharged state. In yet a further aspect, for each bit cell of the array which has been converted to OTP memory, the bit cell can no longer be programmed to the charged state. In another aspect, the corresponding access transistor of each bit cell of the array has a control electrode coupled to the corresponding word line and a second current electrode coupled to the corresponding bit line. In a further aspect, the corresponding access transistor of each bit cell is implemented as a high-voltage device and the corresponding select transistor is a low-voltage device wherein any two terminals of the corresponding access transistor can handle a higher voltage differential without damage as compared to the corresponding select transistor. In another aspect of the above embodiment, the selected bit cell is one of a plurality of selected bit cells which are converted to OTP memory, wherein the controller is configured to, after the plurality of selected bit cells have been converted to OTP memory, perform a refresh operation on all bit cells of the array. In a further aspect, the controller is configured to perform the refresh operation on all bit cells of the array by applying voltages to the corresponding word lines and corresponding bit lines of each bit cell of the array to program each bit cell to the charged state, wherein the plurality of selected bit cells are not changed to the charged state as a result of the refresh operation.

In another embodiment, a DRAM includes an array of bit cells, each bit cell having a corresponding access transistor coupled to a corresponding word line along a corresponding row of the array and a corresponding bit line along a corresponding column of the array, a corresponding storage transistor having a gate electrode coupled to a first current electrode of the corresponding access transistor, a corresponding capacitor having a first terminal coupled to the gate electrode of the storage transistor, and a corresponding diode coupled between a second terminal of the corresponding capacitor and a corresponding voltage supply rail along the corresponding row of the array; and a controller configured to, for each row of the array, apply a first voltage to the corresponding word line along the row of the array to turn on the corresponding access transistors of each of the bit cells along the row of the array, and apply a second voltage to the corresponding voltage supply rail along the row; for a set of selected bit cells of the row, apply a third voltage to the corresponding bit line of each of the set of selected bit cells; and for a set of unselected bit cells of the row, apply a fourth voltage to the corresponding bit line of each of the set of unselected bit cells, in which a differential between the third and second voltage is sufficient to permanently break down a dielectric of the corresponding capacitor of each of the set of selected bit cells such that each of the set of selected bit cells is permanently programmed to a discharged state. In one aspect of the another embodiment, for each row of the array, when the controller applies the first, second, third, and fourth voltages, a differential between the fourth and second voltage disables a diode path of the corresponding diode of each of the set of unselected bit cells. In a further aspect, the third voltage is greater than the fourth voltage, and the second voltage is less than the fourth voltage. In another aspect of the another embodiment, the controller is configured to, after applying the first, second, third, and fourth voltages for each row of the array, perform a refresh operation on the array, wherein, for the refresh operation, the controller is configured to, for each row of the array, refresh each bit cell of the row by applying voltages to each bit cell of the row in an attempt to program each bit cell of the row to a charged state, wherein the refresh operation results in programming a refreshed bit cell to the charged state only if the dielectric of the corresponding capacitor has not been permanently broken down. In another aspect, the controller is configured to, for each row of the array, apply the first, second, third, and fourth voltages by holding the voltages for at least as long as required for the dielectric of the corresponding capacitor for each of the set of selected bit cells to permanently break down. In yet another aspect, the controller is configured to, prior to permanently breaking down dielectrics of any of the corresponding capacitors of any bit cells of the array, perform normal read and write operations to the array, in which any bit cell of the array can be programmed to be in a charged or discharged state.

In yet another embodiment, a DRAM includes an array of bit cells, each bit cell having a corresponding access transistor coupled to a corresponding word line and a corresponding bit line, a corresponding storage transistor having a gate electrode coupled to a first current electrode of the corresponding access transistor, and a corresponding capacitor having a first terminal coupled to the gate electrode of the storage transistor; and a controller. The corresponding access transistor of each bit cell is implemented as a high-voltage device and the corresponding select transistor of each bit cell is implemented as a low-voltage device wherein any two terminals of the high-voltage device can handle a higher voltage differential without damage as compared to the low-voltage device. The controller is configured to convert a selected bit cell of the array of bit cells to one-time-programmable (OTP) memory by turning on the corresponding access transistor of the selected bit cell and applying a voltage differential between the corresponding bit line and the corresponding voltage supply node sufficient to permanently break down a dielectric of the corresponding capacitor. In one aspect of the yet another embodiment, a voltage supply provided to the corresponding bit line of a bit cell to convert the selected bit cell is greater than a highest voltage supply used during normal reads and writes to the array. In another aspect, the corresponding capacitor of each bit cell includes a parasitic capacitor of the bit cell.

## Claims

1. A dynamic random-access memory (DRAM) comprising:
an array of bit cells, each bit cell having a corresponding access transistor coupled to a corresponding word line and a corresponding bit line, a corresponding storage transistor having a gate electrode coupled to a first current electrode of the corresponding access transistor, a corresponding capacitor having a first terminal coupled to the gate electrode of the storage transistor at a corresponding storage node, and a corresponding diode coupled between a second terminal of the corresponding capacitor and a corresponding voltage supply node; and
a controller configured to convert a selected bit cell of the array of bit cells to one-time-programmable (OTP) memory by turning on the corresponding access transistor of the selected bit cell and applying a voltage differential between the corresponding bit line and the corresponding voltage supply node sufficient to permanently break down a dielectric of the corresponding capacitor.

2. The DRAM of claim 1, wherein, for each bit cell, an anode of the corresponding diode is coupled to the second terminal of the corresponding capacitor, and a cathode of the corresponding diode is coupled to the corresponding voltage supply node.

3. The DRAM of claim 2, wherein the controller is configured to, during OTP conversion of the selected bit cell to OTP memory, supply a negative voltage to the corresponding voltage supply node.

4. The DRAM of claim 2 or 3, wherein the controller is configured to, during read, write, and retention operations on bit cells of the array, supply a voltage to the corresponding voltage supply node to turn off a diode path through the corresponding diode.

5. The DRAM of any preceding claim, wherein the corresponding storage node of each bit cell of the array, prior to OTP conversion, is programmable to a charged state or a discharged state, in which the charged state corresponds to a first logic state and the discharged state to a second logic state, different than the first logic state.

6. The DRAM of claim 5, wherein after OTP conversion, the selected bit cell is permanently in the discharged state.

7. The DRAM of claim 6, wherein for each bit cell of the array which has been converted to OTP memory, the bit cell can no longer be programmed to the charged state.

8. The DRAM of any preceding claim, wherein the corresponding access transistor of each bit cell of the array has a control electrode coupled to the corresponding word line and a second current electrode coupled to the corresponding bit line.

9. The DRAM of claim 8, wherein the corresponding access transistor of each bit cell is implemented as a high-voltage device and the corresponding select transistor is a low-voltage device wherein any two terminals of the corresponding access transistor can handle a higher voltage differential without damage as compared to the corresponding select transistor.

10. The DRAM of any preceding claim, wherein the selected bit cell is one of a plurality of selected bit cells which are converted to OTP memory, wherein the controller is configured to, after the plurality of selected bit cells have been converted to OTP memory, perform a refresh operation on all bit cells of the array.

11. The DRAM of claim 10, wherein the controller is configured to perform the refresh operation on all bit cells of the array by applying voltages to the corresponding word lines and corresponding bit lines of each bit cell of the array to program each bit cell to the charged state, wherein the plurality of selected bit cells are not changed to the charged state as a result of the refresh operation.
